# FASCICULE DE BREVET EUROPEEN

(11) **EP 1 593 152 B1**
(45) Date de publication et mention de la délivrance du brevet: **25.01.2012**
(21) Numéro de dépôt: 04710053.2
(22) Date de dépôt: 11.02.2004
(51) Int. Cl.: H01L 21/762, H01L 21/20

(54) **STRUCTURE SEMI-CONDUCTRICE SUR SUBSTRAT A FORTE RUGOSITE**
HALBLEITENDE STRUKTUR AUF EINEM SUBSTRAT MIT STARKER RAUHEIT
SEMICONDUCTOR STRUCTURE ON AN EXTREMELY ROUGH SUBSTRATE

(30) Priorité: 12.02.2003 FR 0301657
(43) Date de publication de la demande: 09.11.2005
(73) Titulaire: S.O.I.TEC Silicon Insulator Technologies, 38190 Bernin (FR)
(72) Inventeur: RAYSSAC, Olivier, F-38100 GRENOBLE (FR); MARTINEZ, Muriel, F-38120 SAINT EGREVE (FR); BISSON, Sephorah, F-38000 GRENOBLE (FR); PORTIGLIATTI, Lionel, F-38180 SEYSSIN (FR)
(74) Mandataire: Desormiere, Pierre-Louis
(86) Numéro de dépôt international: PCT/FR2004/000305
(87) Numéro de publication internationale: WO 2004/075287

(56) Documents cités:
- WO-A-00/03429
- DE-A- 19 936 905
- US-A- 5 782 975
- US-A- 6 146 979
- US-A1- 2001 000 733
- US-A1- 2002 069 816
- US-A1- 2002 192 959
- PATENT ABSTRACTS OF JAPAN vol. 008, no. 013 (E-222), 20 janvier 1984 (1984-01-20) -& JP 58 178519 A (NIPPON DENKI KK), 19 octobre 1983 (1983-10-19)
- DAVID R. LIDE: "CRC Handbook of Chemistry and Physics" 1996, CRC PRESS , BOCA RATON NEW YORK LONDON TOKYO , XP002288762 pages 174-175 pages 177-178

## Description

### Domaine technique et art antérieur

L'invention concerne le domaine des substrats ou des structures pour la réalisation des composants électroniques, ainsi que les procédés de réalisation de tels substrats ou structures.

Elle concerne également les techniques d'assemblage de couches ou de substrats sur des couches rugueuses ou des substrats rugueux.

Elle s'applique aux structures semi-conductrices, et en particulier à celles de type SOI.

Le document US 2002/006 9816 A1 décrit des méthodes de fabrication des couches de nitrure de gallium sur substrat de silicium texturé.

Le document US 5,782,975 décrit une méthode pour fournir un substrat de silicium et de diamant ayant une couche de transition carbone/silicium.

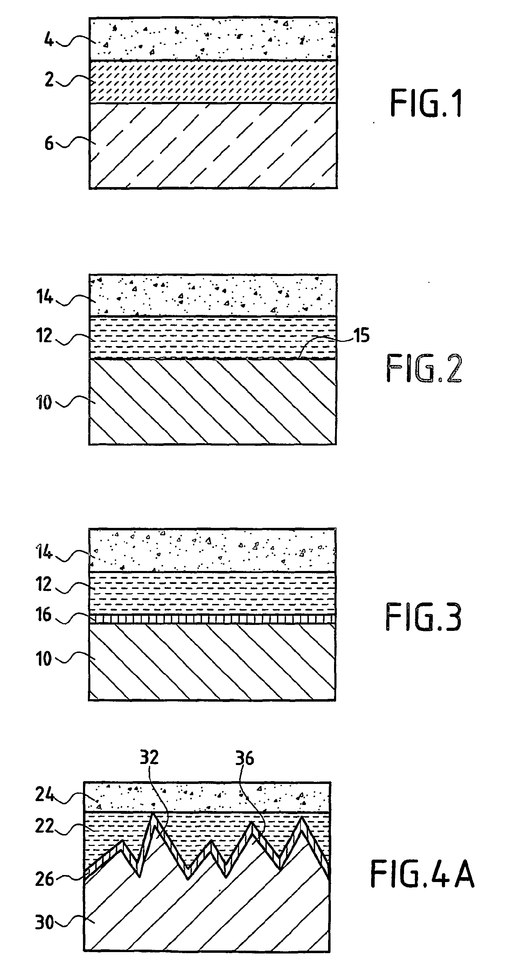

Ces dernières structures comportent, comme illustré sur la figure 1, une couche 4 de silicium, dans laquelle se trouvent les composants proprement dits, et sous laquelle est réalisée une couche enterrée 2 d'oxyde de silicium. Cette dernière constitue une isolation vis-à-vis des courants parasites et des charges provenant de particules ionisées. Elle permet aussi une bonne isolation de composants voisins réalisés dans la même couche de silicium, et notamment une diminution sensible des capacités parasites entre de tels composants voisins. Elle repose elle-même sur un substrat 6 en silicium, qui joue le rôle de support mécanique.

Typiquement, la couche superficielle 4 de silicium a par exemple une épaisseur d'environ 10 à 1000 nm, tandis que la couche d'oxyde 2 a une épaisseur de l'ordre de quelques centaines de nm, par exemple 400 nm.

Ce type de structure peut être obtenu par un procédé de type « SIMOX », ou encore par collage par adhésion moléculaire.

Après réalisation d'un ensemble tel que celui de la figure 1, des composants électroniques peuvent être réalisés dans la couche superficielle 4 de silicium. Celle-ci est donc la couche active, la couche d'oxyde 2 étant une couche d'isolation, le substrat 6 servant de support mécanique et permettant la manipulation de l'ensemble.

Le bon fonctionnement d'un composant, réalisé dans la couche 4, est lié à différents paramètres dont un est l'échauffement, qui peut limiter fortement les performances du composant.

Il se pose donc le problème de trouver une structure de type semi-conducteur sur isolant, et un procédé de réalisation d'une telle structure, dans laquelle les performances de composants, réalisés ensuite dans la couche de semi-conducteur, ne soient pas limitées par l'échauffement, ou soient moins limitées par l'échauffement que dans les structures connues.

Selon un autre aspect de l'invention, les techniques connues d'assemblage de matériaux ne permettent pas de faire adhérer directement ensemble des substrats ou des couches présentant une rugosité supérieure à une certaine valeur limite, de l'ordre de 0,5 nm RMS, ou difficilement polissable, ou présentant une chimie ne permettant pas un collage par adhésion moléculaire.

Or le besoin se fait parfois sentir, de lier entre eux des matériaux ayant chacun une rugosité supérieure à cette valeur limite, ou dont l'un au moins est difficilement polissable, ou présente une chimie ne permettant pas un collage par adhésion moléculaire, ou de lier un tel matériau avec une couche ou un substrat de matériau pouvant déjà être lui-même compatible avec une liaison directe ou par adhésion moléculaire.

### Exposé de l'invention

L'invention concerne tout d'abord une structure semi-conductrice selon la revendication 1.

La couche de matériau semi-conducteur, ainsi que la couche d'adhérence, peuvent être liées par adhérence moléculaire, même si le substrat, ou la couche de base formée dessus, possède une rugosité supérieure à la rugosité limite acceptée pour l'adhérence moléculaire ou « wafer bonding » (qui est d'environ 0,5 nm RMS), ou bien encore si ce substrat, ou la couche de base formée dessus est difficilement polissable ou présente une chimie incompatible avec un collage par adhésion moléculaire.

Il est donc possible d'utiliser un substrat, ou une couche de base, en un matériau tel que par exemple le diamant, ou le nitrure d'aluminium (AIN), qui sont chimiquement inertes, très difficiles à polir et possèdent, même après traitement mécano-chimique, une valeur de rugosité largement supérieure à la valeur limite acceptée par le collage par adhésion moléculaire.

Ces matériaux offrent en outre une forte conductivité thermique, supérieure à 1W/cm/K ou à 10W/cm/K.

Des composants peuvent donc être réalisés dans la couche de matériau semi-conducteur, en particulier des composants de puissance ou de forte puissance ou de type R.F., puisque la chaleur dégagée peut alors être évacuée par le substrat, qui se comporte comme un puits thermique.

De préférence, la surface de la couche d'adhérence tournée vers la couche de matériau semi-conducteur est située à une distance d'au plus 10 nm des aspérités ou pics maximums de la surface du substrat ou de la couche de base, ce qui optimise l'utilisation des propriétés de transfert thermique de la couche supérieure de silicium vers le substrat.

Une couche intermédiaire peut en outre être prévue entre le substrat et la couche d'adhérence. Une telle couche intermédiaire a un coefficient de conductivité thermique compris entre celui de la couche d'adhérence et celui du substrat ou de la couche de base ou supérieur à celui du substrat ou de la couche de base.

Cette couche intermédiaire est par exemple en nitrure de silicium.

Une structure selon l'invention, telle qu'exposée ci-dessus, est compatible avec une adhérence moléculaire de la couche de matériau semi-conducteur, sur la couche d'adhérence.

L'invention concerne également un procédé de réalisation d'une structure semi-conductrice, selon la revendication 13.

La structure selon l'invention est par exemple une structure SOI, le matériau semi-conducteur étant du silicium, et la couche d'adhérence une couche de dioxyde de silicium.

Un procédé est décrite pour lier ou assembler entre eux deux substrats ou couches présentant chacun une rugosité supérieure à 0,5 nm RMS, ou étant difficilement polissable, ou ayant une chimie difficilement compatible avec une adhésion moléculaire, ce procédé comportant :
- former une couche, dite couche d'adhérence, directement sur chaque substrat, ou sur chaque couche à assembler,
- réaliser un collage par adhésion moléculaire, entre les couches d'adhérence.

Egalement un procédé est décrite pour lier ou assembler entre eux deux substrats ou couches, dont l'un(e) présente une rugosité supérieure à 0,5 nm RMS, ou est difficilement polissable, ou a une chimie difficilement compatible avec une adhésion moléculaire, et l'autre une rugosité inférieure à 0,5 nm RMS, ou est facilement polissable, ou offre une chimie compatible avec une adhésion moléculaire, ce procédé comportant :
- former une couche, dite couche d'adhérence, directement sur le substrat, ou sur la couche, dont la rugosité est supérieure à 0,5 nm RMS, ou est difficilement polissable, ou a une chimie difficilement compatible avec une adhésion moléculaire,
- réaliser un collage par adhésion moléculaire, entre cette couche d'adhérence et le substrat ou la couche dont la rugosité est inférieure à 0,5 nm RMS ou est facilement polissable, ou offre une chimie compatible avec une adhésion moléculaire.

### Brève description des figures

- la figure 1 représente une structure SOI connue,
- les figures 2 à 4 représentent diverses structures selon invention,
- les figures 5A à 5D représentent diverses étapes d'un procédé de réalisation d'une structure selon l'invention,
- les figures 6 et 7 représentent d'autres structures selon l'invention.

### Description détaillée de modes de réalisation de l'invention

Un premier exemple d'une structure selon l'invention est donnée en figure 2.

Sur cette figure, la référence 10 désigne un substrat (de préférence en un matériau isolant électrique), la référence 14 une couche ou un substrat en un matériau choisi parmi les matériaux semi-conducteurs, par exemple le silicium ou le Germanium (Ge) ou l'Arséniure de Gallium (AsGa) ou le silicium-germanium (SiGe), ou les composants semiconducteurs III - V ou encore II - VI, et la référence 12 une couche d'adhérence, située entre le substrat 10 et la couche ou le substrat 14.

Le substrat 10 est un substrat dont une surface 15 est rugueuse, ou possède une rugosité supérieure à 0,4 nm RMS ou à 0,5 nm RMS (RMS = en valeur quadratique moyenne). Ce peut être aussi une surface ayant une chimie qui n'accepte pas une adhésion moléculaire, ou dont les propriétés chimiques ne sont pas compatibles avec une adhésion moléculaire. Ce substrat peut avoir une épaisseur comprise entre, par exemple, 100 µm et 2 mm.

En principe, un collage par adhésion moléculaire ne peut être réalisé, ou est très difficile à réaliser, sur un substrat ou une surface possédant une telle rugosité (voir notamment Q.Y. Tong et U. Gösele, Semiconductor Wafer Bonding : Science and Technology, Wiley-Interscience, p.86, 1999).

Le substrat 10 peut aussi être en un matériau difficilement polissable, c'est-à-dire qu'une rugosité inférieure à 0,4 nm RMS ou 0,5 nm RMS ne peut être atteinte qu'après une très longue durée de polissage : pratiquement, on ne pourra donc utiliser un tel matériau qu' avec une rugosité supérieure à 0,4 ou à 0,5 nm RMS.

La tenue mécanique d'un assemblage, comportant par exemple un tel substrat et une couche ou un substrat en un matériau semi-conducteur, assemblés par adhésion moléculaire, peut être mesurée à l'aide de l'onde de collage, par exemple en transmission Infra-Rouge dans du silicium, ou en transparence dans le cas de matériaux transparents, ou par microscopie acoustique en présence de couches métalliques. Elle peut aussi s'apprécier par mesure de l'énergie de collage par la technique de la lame (décrite par exemple dans W.P.Maszara et al, J. Appl. Phys., Vol. 64, p. 4943, 1988): à température ambiante, et dans le cas hydrophile, cette énergie est supérieure à 60 mJ/m2, par exemple supérieure à 70 mJ/m2 ou même à 100 mJ/m2, si il y a effectivement collage.

La réalisation ou la non-réalisation d'un collage par adhésion moléculaire peut donc être déterminée par ces mesures de tenue mécanique.

Le diamant, ou le nitrure d'aluminium (AIN) sont des exemples de matériaux pouvant être utilisés pour le substrat 10 : ils ont des rugosités bien au-delà de la valeur de 0,5 nm RMS : la rugosité du diamant est comprise entre 30 nm RMS et 100 nm RMS, celle du nitrure d'aluminium est de l'ordre de 1 nm RMS, ou comprise entre 0,5 nm RMS et 10 nm RMS.

Ces matériaux sont chimiquement inertes, notamment dans le cas de l'utilisation de produits tels que le « caro » (mélange à base d'acide sulfurique et d'eau oxygénée) et le Sc1 (mélange à base d'hydroxyde d'ammonium, d'eau oxygénée et d'eau).

De préférence, le substrat 10 est en un matériau à forte conductivité thermique, par exemple supérieure à 1W/cm/K : c'est le cas du diamant ou du nitrure d'aluminium AIN (3,2 W/cm/K).

Une couche, ou couche de base, elle - même sur un substrat, peut aussi être utilisée à la place du substrat 10. Elle peut alors avoir une épaisseur de quelques dizaines de nm, par exemple comprise entre 50 nm et 300 nm. Le matériau de cette couche présente les mêmes propriétés que celles exposées ci-dessus dans le cas d'un substrat seul : ce matériau est difficilement polissable, ou possède une rugosité supérieure à 0,4 nm RMS ou à 0,5 nm RMS (RMS = en valeur quadratique moyenne), ou présente une surface ayant une chimie qui n'est pas ou qui n'accepte pas une adhésion moléculaire, ou dont les propriétés chimiques ne sont pas compatibles avec une adhésion moléculaire.

Par exemple, le diamant ou le nitrure d'aluminium peut se présenter soit sous forme de substrat, soit sous forme de couche sur un substrat, ce dernier étant par exemple en silicium. Le dépôt du diamant ou du nitrure d'aluminium peut alors être obtenu par technique de type CVD.

Dans la suite, l'expression « substrat » désignera ces deux alternatives.

La couche 12 est appelée couche d'adhérence, et possède, après traitement mécano-chimique, ou polissage, une rugosité inférieure à 5 nm RMS. Elle permet de faire adhérer le matériau du substrat 10 avec la couche ou le substrat 14 en matériau semi-conducteur. Celui-ci est de préférence relié à la couche d'adhérence 12 par adhésion moléculaire.

Selon un exemple, la couche 12 est en dioxyde de silicium. Elle peut aussi être en un matériau de type « coefficient K élevé», tels que ceux décrits dans le MRS Bulletin, Mars 2002, Viol. 27, No 3, « Alternative Gate Dielectrics for Microelectronics » : de tels matériaux sont par exemple l'oxyde de hafnium (HfO2), ou l'oxyde de zirconium (ZrO2), ou l'alumine (Al2O3), ou encore le Y2O3 (oxyde d'ytrium).

Un autre mode de réalisation est illustré sur la figure 3, où des références identiques à celles de la figure 2 y désignent des éléments identiques ou correspondants. Dans la structure illustrée sur cette figure, est en outre incluse une couche 16, intermédiaire entre la couche d'adhérence et le substrat 10. Le coefficient de conductivité thermique de cette couche intermédiaire est compris entre celui de la couche d'adhérence et celui du substrat ou est supérieur à celui du substrat.

Par exemple, pour une couche d'adhérence en dioxyde de silicium (SiO₂) de coefficient de conductivité thermique 0,01 W/cm/K, et pour un substrat en diamant de conductivité thermique 20 W/cm/K, une couche intermédiaire en nitrure de silicium (Si₃ N₄) conviendra, ce matériau ayant un coefficient de conductivité thermique de 0,3 W/cm/K.

Pour une couche 12 de type à coefficient K élevé, on pourra aussi utiliser le nitrure de silicium Si₃ N₄ comme matériau de la couche intermédiaire.

De préférence, le matériau de la couche 16 est beaucoup plus résistant ou sélectif que celui de la couche 12 par rapport à des traitements physico-chimiques ou par rapport à un traitement de polissage tel qu'un polissage mécano-chimique. Par contre, il est préférable de sélectionner pour le matériau de la couche 16 un matériau dont les propriétés concernant le collage par adhésion moléculaire sont semblables à celles du matériau de la couche 12, qu'il s'agisse d'une adhésion moléculaire hydrophile ou hydrophobe.

La figure 4A représente une structure semblable à celle de la figure 3, les rugosités de la surface supérieure du substrat 30 étant cependant amplifiées ou exagérées.

La couche 22 d'adhérence a été polie, jusqu'à affleurer les pics supérieurs 32, 36 de la surface du substrat 30. Ces pics vont créer des canaux de conduction thermique qui vont favoriser le transfert thermique entre la couche de silicium 24 et le substrat 30.

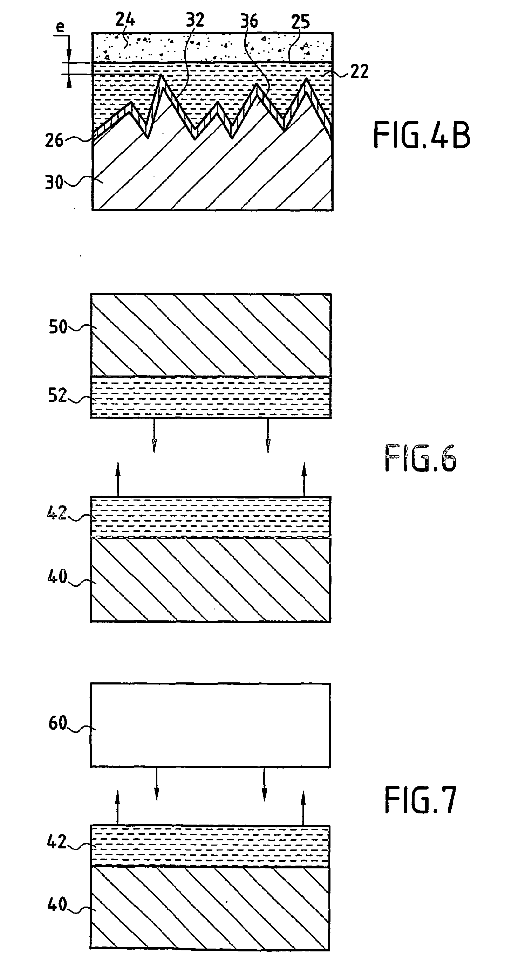

Selon une variante, illustrée en figure 4B, la surface 25 de la couche d'adhérence 22 est située à, au maximum, 10 nm du ou des pics ou aspérités maximums du substrat, afin de favoriser au mieux le transfert thermique par les pics ou les aspérités puis par le substrat.

Une telle épaisseur ou distance peut être mesurée à tout instant, par exemple par ellipsométrie, même en cours d'élaboration de la couche d'adhérence.

Les rugosités du substrat sont donc exploitées de manière à favoriser un transfert thermique entre les couches supérieures de la structure, qui contiennent des composants électroniques, et la base du substrat.

Dans le cas du diamant, le transfert thermique entre la couche supérieure de silicium et le substrat en diamant est amélioré d'un facteur environ 60.

Il en résulte que le fonctionnement de composants réalisé dans la couche 24 est lui-même amélioré. De tels composants peuvent donc être des composants de puissance, qui dégagent une puissance calorifique importante, tels que les composants IGBT, et/ou MOSFET, et/ou composants RF (pour fonctionnement rapide).

Typiquement, la couche d'adhérence 12,22 a, après polissage, une épaisseur comprise entre par exemple 5 nm et 50 nm, et la couche intermédiaire 16, 26 a une épaisseur comprise entre 5 nm et 20 nm.

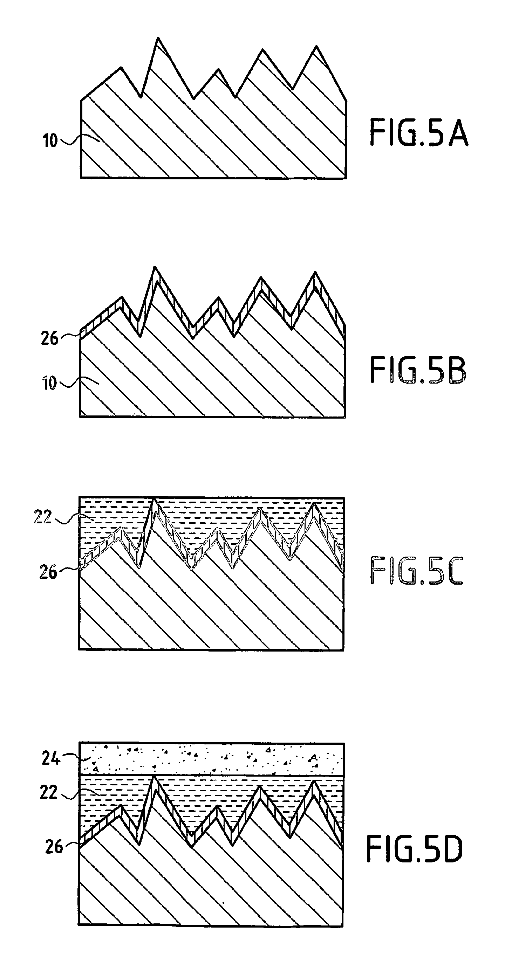

Un procédé de réalisation d'un composant selon l'invention va être décrit en liaison avec les figures 5A à 5D.

La figure 5A représente un substrat 10 dont la rugosité est fortement exagérée. Un tel substrat n'a pas subi de traitement de polissage, ou ne peut être poli, et possède une rugosité ou une micro-rugosité de surface supérieure à la valeur limite acceptée par le collage par adhésion moléculaire, par exemple une rugosité ou une micro-rugosité de surface comprise entre 5 nm RMS (ou 20 ou 30 nm RMS) et 100 nm RMS.

Une couche intermédiaire 26, ici en Si₃N₄, est réalisée sur le substrat.

Cette couche épouse les rugosités de la surface supérieure du substrat. Elle est par exemple déposée par technique PECVD ou LPCVD.

Il est ensuite procédé à la formation d'une couche d'adhérence, par exemple une couche en dioxyde de silicium SiO₂. De préférence, l'épaisseur initiale de cette couche est supérieure à 2,8 ou 3 fois la valeur de la rugosité de la surface du substrat 30, afin d'avoir une couche plate après polissage.

Par exemple, cette couche aura initialement une valeur comprise entre 0,5 et 1 µm, ou encore entre 0,5 et 10 µm.

Cette couche d'adhérence subit ensuite un traitement de polissage, par exemple, par polissage mécano-chimique. Certains procédés, tels que le procédé STI (décrit par exemple dans l'article de C.P. Chang et al. « A highly Manufacturable Corner Rounding Solution for 0, 18 µm Shallow Trench Isolation », IEDM 97 - p.661), présentent une sélectivité importante entre le nitrure 26 et la couche d'oxyde 22. Une telle sélectivité permet d'aplanir la couche 22 jusqu'à ce que la couche 26 soit atteinte, cette dernière servant alors de couche d'arrêt au procédé d'aplanissement.

Une couche ou un substrat en silicium 24 peut ensuite être fixée ou collée sur la couche 22 par adhésion moléculaire, selon des techniques connues, par exemple décrites dans l'ouvrage de Tong et Gösele déjà cité ci-dessus.

Il est possible de réaliser l'adhésion d'un substrat en silicium puis de réaliser une couche mince par amincissement et polissage de ce substrat, ou encore d'utiliser la technique dite « SMART CUT », par exemple décrite dans l'article de A.J. Auberton - Hervé et al. « Why can Smart-Cut change the future of microelectronics?" paru dans Journal of High-Speed Electronics and Systems, Vol.10, No1 (2002), p.131 - 146.

Selon encore une autre technique, on utilise la formation d'une couche de sillicium poreux formant plan de fragilisation, par exemple comme décrit dans l'article de K.Sataguchi et al. « Eltran by Splitting Porous Si layers », Proceedings of the 9th International Symposium on Silicon-on-Insulator Tech. and Device, 99 - 3, The Electrochemical Society, Seattle, p.117 -121, 1999.

On obtient donc une structure telle que celle de la figure 5D, similaire à la figure 4A.

Des composants peuvent ensuite être réalisés dans la couche 24, en particulier des composants de puissance ou R.F., pour lesquels le substrat 10 peut éliminer la chaleur produite lors de leur fonctionnement.

Un autre exemple de mode de réalisation de l'invention est illustré en figure 6.

Il concerne la liaison entre un substrat 40 ou une couche 40 de forte rugosité (supérieure à 0,4 nm RMS ou 0,5 nm RMS, par exemple comprise entre 1 nm RMS et 100 nm RMS), ou difficilement polissable ou ayant une chimie difficilement compatible avec un collage par adhésion moléculaire, et un substrat 50 ou une couche 50 ayant les mêmes propriétés. Par exemple, le substrat 40 est en diamant tandis que le substrat 50 est en diamant ou en AIN (nitrure d'aluminium).

Sur chaque substrat, une couche d'adhérence 42, 52 est formée, comme déjà expliqué ci-dessus, directement ou avec une couche intermédiaire, également comme déjà expliqué ci-dessus. Chacune de ces couches d'adhérence est par exemple en dioxyde de silicium. Il est ensuite possible d'établir une liaison par adhérence moléculaire entre ces deux couches d'adhérence.

Ce procédé est notamment intéressant dans le cas où au moins l'un des deux matériaux est difficilement polissable et est chimiquement inerte, au sens déjà indiqué ci-dessus.

Tout ce qui a été expliqué ci-dessus reste donc valable, en remplaçant la couche de silicium ou de matériau semi-conducteur par un ensemble substrat rugueux - couche d'adhérence.

Plus généralement , l'invention concerne aussi, comme illustré sur la figure 7, la liaison entre un substrat 40 ou une couche 40 difficilement polissable ou de forte rugosité, en tout cas supérieure à 0,5 nm RMS, par exemple comprise entre 1 nm RMS et 100 nm RMS, ou ayant une chimie incompatible avec une liaison par adhérence moléculaire, et un substrat 60 ou une couche 60 ayant une chimie et une rugosité compatibles avec une liaison par adhésion moléculaire, la rugosité étant inférieure à 0,5 nm RMS.

Sur le substrat 40, une couche d'adhérence 42 est formée, directement ou avec une couche intermédiaire comme expliqué ci-dessus. La couche d'adhérence est par exemple en dioxyde de silicium. Il est ensuite possible d'établir une liaison par adhérence moléculaire entre cette couche d'adhérence et la couche ou le substrat 60.

Tout ce qui a été expliqué ci-dessus reste donc valable, en remplaçant la couche de silicium ou de matériau semi-conducteur par la couche ou le substrat 60.

Dans ces deux derniers cas, le matériau de chaque substrat difficilement polissable, ou à rugosité supérieure à 0,5 nm RMS, ou à chimie incompatible avec un collage par adhésion moléculaire, peut être par exemple choisi parmi les matériaux déjà mentionnés ci-dessus (diamant, nitrure d'aluminium AIN).

## Revendications

1. Structure, comportant :
- un premier substrat (10, 30), ou une première couche, présentant une surface ayant une rugosité supérieure à 0,5 nm RMS, ou dont la chimie n'est pas compatible avec une adhésion moléculaire, et ayant une conductivité thermique supérieure à 1W/cm/K,
- un deuxième substrat (14, 24), ou une deuxième couche de matériau choisi parmi les matériaux semi-conducteurs,
- une couche (12, 22), dite couche d'adhérence, située entre le premier substrat, ou la première couche, et le deuxième substrat, ou la deuxième couche,
**caractérisée en ce que** le deuxième substrat (14, 24), ou deuxième couche, est collé sur le premier substrat (10, 30), ou première couche, via ladite couche d'adhérence et **en ce qu'**au moins une partie de la surface de la couche d'adhérence en contact avec le deuxième substrat, ou la deuxième couche, est située à une distance d'au plus 10 nm de la surface, ou des aspérités ou pics maximums, du premier substrat ou de la première couche.

2. Structure selon la revendication 1, le premier substrat, ou la première couche, étant en diamant ou en nitrure d'aluminium.

3. Structure selon la revendication 1 ou 2, comportant en outre une couche intermédiaire (16, 26) entre le premier substrat, ou la première couche, et la couche d'adhérence, dont le coefficient de conductivité thermique est compris entre celui de la couche d'adhérence et celui du premier substrat ou de la première couche, ou supérieure à celui du substrat ou de la couche.

4. Structure selon la revendication 3, la couche intermédiaire étant en nitrure de silicium.

5. Structure selon l'une des revendications 1 à 4, la couche d'adhérence (12, 22) et le deuxième substrat (14, 24), ou la deuxième couche, étant liés par adhésion moléculaire.

6. Structure selon l'une des revendications 1 à 5, la couche d'adhérence ayant une épaisseur comprise entre 5 nm et 20 nm.

7. Structure selon l'une des revendications 1 à 6, la couche d'adhérence étant en dioxyde de silicium (Si02) ou en nitrure de silicium (Si3N4), ou en oxyde de hafnium, ou en oxyde de zirconium, ou en alumine, ou en oxyde d'ytrium.

8. Structure selon l'une quelconque des revendications 1 à 7, le matériau semi-conducteur étant du silicium ou du germanium ou de l'arséniure de gallium, ou du silicium-germanium, ou un composé semi-conducteur III - V ou II - VI.

9. Structure selon la revendication 8, la structure étant de type SOI.

10. Structure selon la revendication 7 ou 8, au moins un composant de puissance et/ou au moins un composant RF étant réalisé dans le deuxième substrat, ou la deuxième couche de matériau choisi parmi les matériaux semi-conducteurs.

11. Structure selon l'une des revendications 7 à 10, comportant au moins un composant de type IGBT ou MOSFET dans le deuxième substrat, ou la deuxième couche de matériau choisi parmi les matériaux semi-conducteurs.

12. Structure selon l'une des revendications 1 à 11, le deuxième substrat (14, 24) ou la deuxième couche présentant une rugosité supérieure à 0,5 nm RMS, ou ayant une chimie incompatible avec un collage par adhésion moléculaire.

13. Procédé de réalisation d'une structure, sur un premier substrat (10, 30) ou une première couche, présentant une rugosité supérieure à 0,5 nm RMS, ou dont la chimie n'est pas compatible avec une adhésion moléculaire, et ayant une conductivité thermique supérieure à 1W/cm/K, comportant les étapes suivantes :
- former une couche (12, 22), dite couche d'adhérence, directement sur le premier substrat ou la première couche, ou sur une couche intermédiaire (16, 26) dont le coefficient de conductivité thermique est compris entre celui de la couche d'adhérence et celui du substrat ou de la couche de base ou est supérieur à celui du premier substrat ou de la première couche,
- aplanir ladite couche d'adhérence,
**caractérisé en ce que** l'on réalise un collage par adhésion moléculaire entre une deuxième couche ou un deuxième substrat (14, 24) en un matériau semi-conducteur et la couche d'adhérence et **en ce qu'**au moins une partie de la surface de la couche d'adhérence en contact avec le deuxième substrat, ou la deuxième couche, est située à une distance d'au plus 10 nm de la surface, ou des aspérités ou pics maximums, du premier substrat ou de la première couche.

14. Procédé selon la revendication 13, le premier substrat ou la première couche étant en diamant ou en nitrure d'aluminium.

15. Procédé selon la revendication 13 ou 14, la couche intermédiaire étant en nitrure de silicium.

16. Procédé selon l'une des revendications 13 à 15, la couche d'adhérence étant en dioxyde de silicium ou en nitrure de silicium ou en oxyde de hafnium, ou en oxyde de zirconium, ou en alumine, ou en oxyde d'ytrium.

17. Procédé selon l'une des revendications 13 à 15, la couche d'adhérence ayant, avant aplanissement, une épaisseur supérieure à 2,8 fois la valeur de la rugosité du premier substrat ou de la première couche.

18. Procédé selon la revendication 13, comportant en outre une étape de réalisation d'au moins un composant de puissance et/ou d'au moins un composant R.F. dans le deuxième substrat ou la deuxième couche.

19. Procédé selon l'une des revendications 13 à 17, le deuxième substrat ou la deuxième (60) couche présentant une rugosité inférieure à 0,5 nm RMS.

20. Procédé selon l'une des revendications 13 à 17, les deux substrats (40, 50) ou couches présentant une rugosité supérieure à 0,5 nm RMS, ou dont la chimie n'est pas compatible avec une adhésion moléculaire, ce procédé comportant :
- former une couche (42, 52), dite couche d'adhérence, directement sur chaque substrat, ou sur chaque couche à assembler,
- réaliser un collage par adhésion moléculaire, entre ces couches d'adhérence.

21. Procédé selon la revendication 20, le matériau de chacun des substrats (40, 50), ou couches, à rugosité supérieure à 0,5 nm RMS étant choisi parmi le diamant et le nitrure d'aluminium.

## Claims

1. A semiconductor structure, comprising:
• a first substrate (10, 30) or a first layer, having a surface with roughness of more than 0.5 nm RMS or having chemistry that is incompatible with molecular bonding, and having thermal conductivity of more than 1 W/cm/K;
• a second substrate (14, 24), or a second layer of material selected from semiconductor materials;
• a layer (12, 22) termed the bonding layer located between the first substrate or first layer and the second substrate or second layer,
**characterized in that** the second substrate (14, 24), or second layer, is bonded on the first substrate (10, 30), or first layer, via the bonding layer and **in that** at least one part of the surface of the bonding layer contacting the second substrate, or second layer is located at a distance of at most 10 nm from the surface or the maximum peaks or bumps of the first substrate or first layer.

2. A structure according to claim 1, wherein the first substrate or first layer is formed from diamond or aluminum nitride.

3. A structure according to claim 1 or claim 2, further comprising an intermediate layer (16, 26) between the first substrate or first layer and the bonding layer, having thermal conductivity in the range between that of the bonding layer and that of the first substrate or first layer, or higher than that of the substrate or layer.

4. A structure according to claim 3, wherein the intermediate layer is silicon nitride.

5. A structure according to any one of claims 1 to 4, wherein the bonding layer (12, 22) and the second substrate (14, 24), or the second layer, are bonded by molecular bonding.

6. A structure according to any one of claims 1 to 5, wherein the thickness of the bonding layer is in the range 5 nm to 20 nm.

7. A structure according to any one of claims 1 to 6, wherein the bonding layer is formed from silicon dioxide (SiO₂), silicon nitride (Si₃N₄), hafnium oxide, zirconium oxide, alumina, or yttrium oxide.

8. A structure according to any one of claims 1 to 7, wherein the semiconductor material is silicon, germanium, gallium arsenide, silicon-germanium, or a semiconductor III-V or II-VI compound.

9. A structure according to claim 8, wherein the structure is of the SOI type.

10. A structure according to claim 7 or 8, wherein at least one power component and/or at least one RF component is formed in the second substrate or second layer of material selected from semiconductor materials.

11. A structure according to claim 7 or 8, comprising at least one IGBT or MOSFET type component in the second substrate or second layer of material selected from semiconductor materials.

12. A structure according to any one of claims 1 to 11, wherein the second substrate (14, 24) or second layer has roughness of more than 0.5 nm RMS, or has chemistry that is incompatible with molecular bonding.

13. A method of producing a structure on a first substrate (10, 30) or first layer having roughness of more than 0.5 nm RMS or having chemistry that is incompatible with molecular bonding, and having thermal conductivity of more than 1 W/cm/K, comprising the following steps:
• forming a layer (12, 22) termed the bonding layer directly on the first substrate or first layer or on an intermediate layer (16, 26) with a thermal conductivity coefficient that is in the range from that of the bonding layer to that of the first substrate or first layer or is higher than that of the first substrate or the first layer;
• smoothing said bonding layer;
**characterized in that** said method further comprises bonding a second layer or second substrate (14, 24) formed from a semiconductor material to the bonding layer by molecular bonding and **in that** at least one part of the surface of the bonding layer contacting the second substrate, or second layer is located at a distance of at most 10 nm from the surface or the maximum peaks or bumps or the first substrate or first layer.

14. Method according to claim 13, wherein the substrate or base layer is formed from diamond or aluminum nitride.

15. A method according to claim 13 or claim 14, wherein the intermediate layer is formed from silicon nitride.

16. A method according to any one of claims 13 to 15, wherein the bonding layer is formed from silicon dioxide, silicon nitride, hafnium oxide, zirconium oxide, alumina or yttrium oxide.

17. A method according to any one of claims 13 to 15, wherein prior to smoothing, the thickness of the bonding layer is more than 2.8 times the value of the roughness of the first substrate or the first layer.

18. A method according to claim 13, further comprising a step for producing at least one power component and/or at least one RF component in the second substrate or second layer.

19. A method according to any one of claims 13 to 17, wherein the second substrate or second layer (60) presents a roughness of more than 0.5 nm RMS.

20. A method according to any one of claims 13 to 17, the two substrates or layers (40, 50) having roughness of more than 0.5 nm RMS or having chemistry that is incompatible with molecular bonding, said method comprising:
• forming a layer (42, 52) termed the bonding layer directly on each substrate or layer to bond;
• bonding said bonding layers together by molecular bonding.

21. A method according to claim 20, wherein the material of each substrate (40, 50), or layer, having roughness of more than 0.5 nm RMS is selected from diamond or aluminum nitride.

## Patentansprüche

1. Struktur, umfassend:
- ein erstes Substrat (10, 30), oder eine erste Schicht, das eine Oberfläche mit einer Rauhigkeit von über 0,5 nm RMS hat, oder dessen Chemie mit einer molekularen Adhäsion unvereinbar ist, und das eine Wärmeleitfähigkeit von über 1 W/cm/K aufweist,
- ein zweites Substrat (14, 24), oder eine zweite Schicht aus einem Material, das aus den Halbleitermaterialien ausgewählt ist,
- eine Schicht (12, 22), sogenannte Haftschicht, die zwischen dem ersten Substrat, oder der ersten Schicht, und dem zweiten Substrat, oder der zweiten Schicht, gelegen ist,
**dadurch gekennzeichnet, daß** das zweite Substrat (14, 24), oder die zweite Schicht, über die Haftschicht auf das erste Substrat (10, 30), oder die erste Schicht, aufgeklebt ist und daß wenigstens ein Teil der mit dem zweiten Substrat, oder der zweiten Schicht, in Kontakt befindlichen Fläche der Haftschicht in einem Abstand von höchstens 10 nm von der Oberfläche, oder den Unebenheiten oder maximalen Spitzen, des ersten Substrats oder der ersten Schicht gelegen ist.

2. Struktur nach Anspruch 1, wobei das erste Substrat, oder die erste Schicht, aus Diamant oder aus Aluminiumnitrid besteht.

3. Struktur nach Anspruch 1 oder 2, ferner umfassend eine Zwischenschicht (16, 26) zwischen dem ersten Substrat, oder der ersten Schicht, und der Haftschicht, deren Wärmeleitzahl zwischen derjenigen der Haftschicht und derjenigen des ersten Substrats oder der ersten Schicht liegt oder höher als diejenige des Substrats oder der Schicht ist.

4. Struktur nach Anspruch 3, wobei die Zwischenschicht aus Siliziumnitrid besteht.

5. Struktur nach einem der Ansprüche 1 bis 4, wobei die Haftschicht (12, 22) und das zweite Substrat (14, 24), oder die zweite Schicht, durch molekulare Adhäsion verbunden sind.

6. Struktur nach einem der Ansprüche 1 bis 5, wobei die Haftschicht eine Dicke im Bereich zwischen 5 nm und 20 nm aufweist.

7. Struktur nach einem der Ansprüche 1 bis 6, wobei die Haftschicht aus Siliziumdioxid (SiO₂) oder aus Siliziumnitrid (Si₃N₄) oder aus Hafniumoxid oder aus Zirkoniumoxid oder aus Aluminiumoxid oder aus Yttriumoxid besteht.

8. Struktur nach einem der Ansprüche 1 bis 7, wobei das Halbleitermaterial Silizium oder Germanium oder Galliumarsenid oder Silizium-Germanium oder eine III-V- oder II-VI-Halbleiterverbindung ist.

9. Struktur nach Anspruch 8, wobei die Struktur vom Typ SOI ist.

10. Struktur nach Anspruch 7 oder 8, wobei wenigstens ein Leistungsbauteil und/oder wenigstens ein RF-Bauteil in dem zweiten Substrat, oder der zweiten Schicht, aus einem aus den Halbleitermaterialien ausgewählten Material ausgebildet ist.

11. Struktur nach einem der Ansprüche 7 bis 10, umfassend wenigstens ein Bauteil vom Typ IGBT oder MOSFET in dem zweiten Substrat, oder der zweiten Schicht, aus einem aus den Halbleitermaterialien ausgewählten Material.

12. Struktur nach einem der Ansprüche 1 bis 11, wobei das zweite Substrat (14, 24) oder die zweite Schicht eine Rauhigkeit von über 0,5 nm RMS hat oder eine Chemie aufweist, die mit einem Verkleben mittels molekularer Adhäsion unvereinbar ist.

13. Verfahren zur Herstellung einer Struktur auf einem ersten Substrat (10, 30), oder einer ersten Schicht, das eine Rauhigkeit von über 0,5 nm RMS hat, oder dessen Chemie mit einer molekularen Adhäsion unvereinbar ist, und das eine Wärmeleitfähigkeit von über 1 W/cm/K aufweist, umfassend die folgenden Schritte:
- Ausbilden einer Schicht (12, 22), sogenannten Haftschicht, direkt auf dem ersten Substrat oder der ersten Schicht oder auf einer Zwischenschicht (16, 26), deren Wärmeleitzahl zwischen derjenigen der Haftschicht und derjenigen des Substrats oder der Basisschicht liegt oder höher als diejenige des ersten Substrats oder der ersten Schicht ist,
- Einebnen der Haftschicht,
**dadurch gekennzeichnet, daß** zwischen einer zweiten Schicht oder einem zweiten Substrat (14, 24) aus einem Halbleitermaterial und der Haftschicht ein Verkleben mittels molekularer Adhäsion vollzogen wird und daß wenigstens ein Teil der mit dem zweiten Substrat, oder der zweiten Schicht, in Kontakt befindlichen Fläche der Haftschicht in einem Abstand von höchstens 10 nm von der Oberfläche, oder den Unebenheiten oder maximalen Spitzen, des ersten Substrats oder der ersten Schicht gelegen ist.

14. Verfahren nach Anspruch 13, wobei das erste Substrat, oder die erste Schicht, aus Diamant oder aus Aluminiumnitrid besteht.

15. Verfahren nach Anspruch 13 oder 14, wobei die Zwischenschicht aus Siliziumnitrid besteht.

16. Verfahren nach einem der Ansprüche 13 bis 15, wobei die Haftschicht aus Siliziumdioxid oder aus Siliziumnitrid oder aus Hafniumoxid oder aus Zirkoniumoxid oder aus Aluminiumoxid oder aus Yttriumoxid besteht.

17. Verfahren nach einem der Ansprüche 13 bis 15, wobei die Haftschicht vor dem Einebnen eine Dicke aufweist, die größer als das 2,8-fache des Wertes der Rauhigkeit des ersten Substrats oder der ersten Schicht ist.

18. Verfahren nach Anspruch 13, ferner umfassend einen Schritt zur Ausbildung wenigstens eines Leistungsbauteils und/oder wenigstens eines RF-Bauteils in dem zweiten Substrat oder der zweiten Schicht.

19. Verfahren nach einem der Ansprüche 13 bis 17, wobei das zweite Substrat oder die zweite Schicht (60) eine Rauhigkeit von unter 0,5 nm RMS aufweist.

20. Verfahren nach einem der Ansprüche 13 bis 17, wobei die beiden Substrate (40, 50) oder Schichten eine Rauhigkeit von über 0,5 nm RMS aufweisen oder deren Chemie mit einer molekularen Adhäsion unvereinbar ist, wobei dieses Verfahren umfaßt:
- Ausbilden einer Schicht (42, 52), sogenannten Haftschicht, direkt auf jedem Substrat, oder auf jeder zu verbindenden Schicht,
- Durchführen eines Verklebens mittels molekularer Adhäsion zwischen diesen Haftschichten.

21. Verfahren nach Anspruch 20, wobei das Material eines jeden der Substrate (40, 50), oder Schichten, mit einer Rauhigkeit von über 0,5 nm RMS aus Diamant und Aluminiumnitrid ausgewählt ist.
